# EUROPÄISCHE PATENTSCHRIFT

(11) **EP 0 877 067 B1**
(45) Veröffentlichungstag und Bekanntmachung des Hinweises auf die Patenterteilung: **17.03.2004**
(21) Anmeldenummer: 98108105.2
(22) Anmeldetag: 04.05.1998
(51) Int. Cl.: C09D 167/07, C09D 167/06, C09D 175/16, C09D 171/00, C09D 163/10, C08F 299/02

(54) **Wässrige, strahlungshärtbare Beschichtungsmassen**
Aqueous, radiation curable coating compositions
Compositions de revêtement aqueuses, durcissables par irradiation

(30) Priorität: 05.05.1997 DE 19718948
(43) Veröffentlichungstag der Anmeldung: 11.11.1998
(73) Patentinhaber: BASF AKTIENGESELLSCHAFT, 67056 Ludwigshafen (DE)
(72) Erfinder: Reich, Wolfgang, 67133 Maxdorf (DE); Enenkel, Peter, 67258 Hessheim (DE); Keil, Edmund, 67259 Heichhelheim (DE); Lokai, Matthias, 67677 Enkenbach-Alsenborg (DE); Beck, Erich, 68528 Ladenburg (DE); Menzel, Klaus, 71696 Möglingen (DE)
(74) Vertreter: Kinzebach, Werner, Dr.

(56) Entgegenhaltungen:
- EP-A- 0 084 312
- EP-A- 0 584 734

## Beschreibung

Die vorliegende Erfindung betrifft ein Verfahren zur Herstellung beschichteter Oberflächen sowie wässrige, strahlungshärtbare Beschichtungsmassen, die mindestens ein wasserdispergierbares Polymerisat oder eine wässrige Polymerdispersion auf Basis eines solchen Polymerisats sowie mindestens eine weitere, von dem Polymerisat verschiedene, wasserlösliche oder wasserverdünnbare, strahlungshärtbare Verbindung umfassen.

Strahlungshärtbare Lacke, zum Beispiel auf Basis von Polyester- und Polyetheracrylaten und -methacrylaten haben eine große technische Bedeutung erlangt und breite Anwendung gefunden. Aufgrund ihrer Vernetzbarkeit eignen sie sich vor allem zur Herstellung strahlungshärtbarer Überzugsmassen, z. B. von Lack-Formulierungen, welche durch UV- bzw. Elektronenstrahlen schnell gehärtet werden können. Sie werden sowohl zum Beschichten von nichtsaugenden Substraten, wie Glas, Kunststoffen und Metallen, als auch von saugenden Substraten, wie Holz, Papier und Leder eingesetzt. Um eine Belastung der Umwelt durch Lösungsmittelemissionen zu vermeiden und entsprechenden Rechtsvorschriften zu genügen, werden überwiegend strahlungshärtbare Lack-Formulierungen auf Basis wässriger Polymerisatdispersionen eingesetzt. Da die Haftung von wasserbasierenden Lacken auf nichtsaugenden Substraten aufgrund des Polymerisationsschrumpfes, aber auch auf verschiedenen saugenden Substraten meist sehr schlecht ist, müssen diese Oberflächen mit einer entsprechenden Grundierung (Primer) vorbehandelt werden. Aufgrund der erwähnten Umweltaspekte werden dabei vorzugsweise Grundierungen eingesetzt, die ebenfalls auf Wasser basieren.

Die DE-A-41 14 518 beschreibt Grundierungen zur Erzeugung von harten, widerstandsfähigen Oberflächen auf Holz und vergleichbaren Trägermaterialien auf Basis von wasserverdünnbaren, formaldehydarmen, Melamin-Formaldehyd- bzw. Melamin-Harnstoff-Formaldehyd-Kondensationsprodukten. Diese Grundierungen sowie anschließend aufgetragene Deckschichten werden unter Erwärmung getrocknet.

Die DE-A-37 40 139 beschreibt ein Verfahren zur Grundierung von Wasserlacken auf Holz, wobei ein weichmacherhaltiges Kunstharz eingesetzt wird, um eine füllkräftige Grundierung zu erhalten, welche sich gut im Holz verankert und eine sichere Verbindung mit dem Decklack bringt.

Die US-A-4,782,109 beschreibt eine Farbe auf Basis einer Lösung eines zweiphasigen Harzes, wobei die innere Phase ein Pigment und einen Latex, und die äußere Phase ein in Wasser gelöstes, aminlösliches Harz umfasst. Geeignete aminlösliche Harze sind zum Beispiel Styrol-Acrylharze, Polyvinylacetat-Copolymere, Acryl-Copolymere und Styrol-Butadien-Copolymere. Die Farbformulierungen eignen sich unter anderem auch als Primer für Metalle und Holz.

Die DE-A-21 08 365 beschreibt Alkydharz-modifizierte Dispersionen, die zur Herstellung von Anstrichfarben und Armierungsklebern dienen. Mit ihnen lassen sich auch elastische Anstrichbeschichtungen auf verschiedenen Untergründen, wie Holz, Beton und Mauerwerk, herstellen. Aufgrund der guten Haftung sollen sich diese Dispersionen auch zur Herstellung von Grundierungen eignen.

Die EP-A-0 496 205 beschreibt wässrige Bindemittelkombinationen, die im wesentlichen aus A) einer wässrigen Lösung oder Dispersion einer wasserverdünnbaren, organischen Polyolkomponente und B) einer Polyisocyanatkomponente, welche in der Komponente A) emulgiert vorliegt, bestehen. Dabei besteht die Polyolkomponente aus mindestens einem Urethan-, Carboxylat- und Hydroxylgruppen aufweisenden Polyesterharz. In den angegebenen Beispielen werden Komponenten A) mit einem Feststoffgehalt von maximal 47,6 Gew.-% eingesetzt. Diese Bindemittelkombinationen eignen sich zur Herstellung von Lacken und Beschichtungsmassen, zur Beschichtung mineralischer Baustoffe, Lackierung und Versiegelung von Holz und Papier etc.

Die DE-A-35 02 944 beschreibt wässrige Grundierungen für Holzanstriche, die eine Dispersion eines Vinylpolymerisats und einen wasserlöslichen Zinkaminkomplex enthalten. Diese Grundierungen sollen transparente, lichtfeste Filme liefern und das Ausbluten von Holzinhaltsstoffen und die dadurch bedingte Fleckenbildung vermeiden.

Die EP-A-0 583 728 beschreibt wasserverdünnbare Zweikomponenten-Überzugsmassen, die eine Polyisocyanatkomponente und ein Polyesterharz umfassen. Dabei sind die esterbildenden Derivate ausgewählt unter Dicarbonsäuren, difunktionellen Sulfo- oder Phosphonomonomeren, Glykolen, höherfunktionellen Carboxyl- und/oder Hydroxylgruppen-enthaltenden Verbindungen und monofunktionellen Carbonsäuren. Diese Massen eignen sich besonders für die Herstellung von Grundierungen, Füllern, Decklacken und Einschichtlacken.

In der JP-A-01304935 werden wässrige Primer für flammhemmende Lacke auf Basis eines Polyvinylalkohols und/oder Polyacrylamids beschrieben.

In der JP-A-55039239 werden Primer für Holz beschrieben, die aus aliphatischen Diaminen, Glycidylestern ungesättigter Säuren und einem Radikalinitiator bestehen.

Des weiteren sind Grundierungen auf Basis wässriger Dispersionen, z. B. Styrol-Butadien-Latices, Styrol-Acrylat-Emulsionen, Vinylacetat/Acrylcopolymer-Latices und Alkydharzemulsionen als Grundierungen für Holz bekannt. In Ind. Vernici 1981, Vol. 35, No. 11, 7 - 13, werden wässrige Acrylatemulsionen als Primer beschrieben.

In Journal of Coatings Technology, Vol. 51, No. 654, July 1979, S. 45 - 51, werden verschiedene Latex-Primer beschrieben.

Die zuvor genannten, wässrigen Grundierungen sind selbst nicht strahlungshärtbar und eine mögliche Verwendung als Grundierungen für strahlungshärtbare Lacke wird in keiner der Publikationen beschrieben.

Die DE-A-36 16 434 beschreibt ein Verfahren zur Grundierung von Holz, wobei die Grundierung mittels UV-Strahlen gehärtet wird. Dabei wird zuerst ein Polyisocyanat in einem organischen Lösungsmittel, z. B. Ethylacetat, als Haftgrund vorappliziert und nach dem Abdunsten des Lösungsmittels die UV-Grundierung, im allgemeinen übliche Acrylatprepolymere, z. B. Polyesteracrylate, Polyepoxyacrylate und Polyurethanacrylate, aufgetragen und durch UV-Strahlen gehärtet. Nach Anschliff kann auf diese Grundierung ein für die Holzlackierung üblicher Decklack aufgetragen werden. Dieses Verfahren ist aufgrund der notwendigen Vorapplizierung des Isocyanates technisch aufwendig. Zudem lässt man die eingesetzten organischen Lösungsmittel abdunsten, was eine technisch ebenfalls aufwendige Abluftbehandlung erforderlich macht.

Die US-A-4,171,387 beschreibt ein Verfahren zur Herstellung von beschichteten Substraten, z. B. aus Holz, wobei auf das Substrat zuerst ein Urethanbindemittel mit einem Feststoffgehalt von etwa 25 bis 35 Gew.-% aufgetragen und getrocknet wird, und anschließend auf dieses Bindemittel eine UV-härtbare Polyacrylatharz-Zusammensetzung aufgetragen und durch UV-Bestrahlung gehärtet wird. Dabei wird das Urethanharz in einem Gemisch aus organischen Lösungsmitteln, z. B. aus Methylethylketon und Toluol, aufgetragen und unter Erwärmen getrocknet.

Die DD-A-252 983 beschreibt eine Isolationsschicht aus Harnstoff-Formaldehydharzen zum Auftragen auf Hölzern, deren Inhaltsstoffe die Härtung von Lacken, z. B. ungesättigten Polyestern, inhibieren.

Die DD-A-160 660 beschreibt Grundierungen für UV-Lacke. Ziel ist die Verbesserung der physikalisch-mechanischen Eigenschaften des Endprodukts, die Erhöhung der Stabilität des Grundanstrichs und die Beschleunigung seiner photochemischen Härtung.

Keine der zuvor genannten Schriften beschreibt strahlungshärtbare Grundierungen auf Basis von Polymerdispersionen für strahlungshärtbare Decklacke.

Die DE-A-32 35 610 beschreibt ein strahlungshärtbares Grundierungsmittel auf der Basis von (Meth)acryloylgruppen-haltigen Prepolymeren und üblichen Hilfsstoffen. Diese Grundiermittel sind gekennzeichnet durch ihren Gehalt an organischen und/oder anorganischen Fasern. Sie sind besonders zum kontinuierlichen Beschichten von Holzbetonformkörpern, wie z. B. Holzbetonplatten, geeignet.

Die DE-A-16 21 820 beschreibt ein Verfahren zum Grundieren von Holz und holzähnlichen Stoffen für Lacke und andere Deckschichten, wobei ein lichthärtendes Kunstharz mit einem Anteil von 10 bis 60 % an anorganischen Füllstoffen, wie z. B. Siliciumdioxid, verwendet wird. In der Publikation wird nicht angegeben, welche UV-härtenden Kunstharze eingesetzt werden.

Die JP-A-52033929 beschreibt einen UV- oder elektronenstrahlhärtbaren Holzprimer, der aus einer Mischung aus einem Polyacrylat (aus Methylmethacrylat, Ethylacrylat, Glycidylmethacrylat und Methacrylsäure), Hexandioldimethacrylat, Glycidylmethacrylat und Hydroxyethylacrylat besteht. Der Primer wird auf Holz appliziert, mit einem Decklack aus einem ungesättigten Polyester überzogen und mit Elektronenstrahlen ausgehärtet.

In Lakokras. Mater. IKH. Primen (1978), (6), 67, wird ein Primer auf Basis eines ungesättigten Polyesters beschrieben, der mit einem Photoinitiator versetzt und mittels UV-Strahlen vernetzt wird.

In Derevoobrab. Prom-st. (1979), (7), 6, werden ungesättigte Polyester als Primer beschrieben, die auf Holz aufgetragen, mittels UV-Strahlen ausgehärtet und anschließend mit ungesättigten Polyestern überlackiert werden, die ebenfalls mit UV-Licht ausgehärtet werden.

Die EP-A- 0 012 339 beschreibt strahlungshärtbare, wässrige Bindemitteldispersionen, umfassend:
A) 20 bis 80 Gew.-% Wasser,
B) 80 bis 20 Gew.-% mindestens eines in A) dispergierten Präpolymeren mit polymerisierbaren C=C-Doppelbindungen, sowie zusätzlich
C) 0,1 bis 30 Gew.-%, bezogen auf B), mindestens eines Dispergierhilfsmittels, und
D) 0 bis 20 Gew.-%, bezogen auf B), mindestens eines Photoinitiators.

Geeignete Komponenten B) sind Polyester, die polymerisierbare C=C-Doppelbindungen enthalten, z. B. Polyesteracrylate, Polyether, welche polymerisierbare C=C-Doppelbindungen enthalten, wie z.B. Polyether mit freien Hydroxylgruppen, welche ganz oder teilweise mit ethylenisch ungesättigten Alkoholen verethert sind, Ester aus Polyepoxiden mit endständigen Hydroxylgruppen und α,β-ethylenisch ungesättigten Carbonsäuren, Polyurethan(meth)acrylate und Polymere mit polymerisierbaren Doppelbindungen, die durch Einführung von α,β-ethylenisch ungesättigten Acylresten in Acrylat-Copolymere erhältlich sind. Diese strahlungshärtbaren, wässrigen Bindemitteldispersionen eignen sich gut für die Beschichtung von nichtmetallischen, organischen Substraten, wie Leder, Papier oder Holz. Obwohl wässrige Beschichtungsmittel mit hohem Festkörpergehalt beschrieben werden, liegt der in den Beispielen für die wässrigen Bindemitteldispersionen angegebene Feststoffgehalt bei maximal 65 Gew.-%. Es findet sich kein Hinweis auf eine mögliche Verwendung der strahlungshärtbaren, wässrigen Bindemitteldispersionen als Grundierungen für strahlungshärtbare Decklacke.

Die EP-A-0 704 469 beschreibt strahlungshärtbare, wässrige Polyurethandispersionen, die mindestens eine copolymerisierbare, ungesättigte Gruppe umfassen, sowie deren Verwendung als Beschichtungsmittel für nichtsaugfähige Substrate, wie Metall, Kunststoff, Glas und poröse Substrate, wie z. B. Leder, Papier und Holz. Es ist nicht offenbart, dass zusätzlich zu den eingesetzten Polyurethanen noch weitere strahlungshärtbare Verbindungen enthalten sein können. Der Gehalt des Polyurethans in den Dispersionen wird mit 5 bis 70 Gew.-% angegeben, wobei in den Beispielen jedoch nur Dispersionen mit einem Feststoffgehalt von maximal 40 Gew.-% beschrieben sind. Des weiteren findet sich auch kein Hinweis auf eine mögliche Verwendung der wässrigen Dispersionen als Grundierung für wässrige, strahlungshärtbare Decklacke.

Der vorliegenden Erfindung liegt die Aufgabe zugrunde, wässrige, strahlungshärtbare Beschichtungsmassen als Primer für strahlungshärtbare Lacke zur Verfügung zu stellen. Diese sollen die Haftung der strahlungshärtbaren Lacke sowohl auf nichtsaugenden Substraten, wie Metallen, als auch insbesondere auf saugenden Substraten, wie Leder, Papier, Holz und Holzwerkstoffen, verbessern. Bevorzugt sollen diese Grundierungen auch einen möglichst hohen Feststoffgehalt aufweisen, um nach dem Auftragen auf das Substrat eine gute Trocknung zu ermöglichen.

Überraschenderweise wurde nun gefunden, dass diese Aufgabe durch Bereitstellung des erfindungsgemäßen Verfahrens und von wässrigen, strahlungshärtbaren Beschichtungsmassen gelöst wird, die mindestens ein wasserdispergierbares Polymerisat oder eine wässrige Polymerdispersion auf Basis dieses Polymerisats sowie mindestens eine weitere, von diesem Polymerisat verschiedene, wasserlösliche oder wasserverdünnbare, strahlungshärtbare Verbindung enthalten. Überraschenderweise wurde weiterhin gefunden, dass diese Beschichtungsmassen in Abhängigkeit von ihrem Auftragsgewicht bereits ab einem Feststoffgehalt von mindestens 65 Gew.-% bei der Beschichtung saugfähiger Substrate im allgemeinen einen Verzicht auf eine physikalische Trocknung der Beschichtung vor der Strahlungshärtung ermöglichen.

Ein Gegenstand der vorliegenden Erfindung ist ein Verfahren zur Herstellung beschichteter Oberflächen, dadurch gekennzeichnet, dass man
i) eine wässrige, strahlungshärtbare Beschichtungsmasse auf die Oberfläche aufträgt, enthaltend:
   a) 5,0 bis 90,0 Gew.-% mindestens eines wasserdispergierbaren Polymerisats P, umfassend wenigstens eine α,β-ethylenisch ungesättigte, durch Strahlung polymerisierbare Doppelbindung,
   b) 0,1 bis 90 Gew.-% mindestens einer von P verschiedenen; wasserlöslichen oder mit mindestens 10 Gew.-% Wasser, bezogen auf das Gesamtgewicht der Beschichtungsmasse, verdünnbaren, strahlungshärtbaren Verbindung S, die wenigstens eine α,β-ethylenisch ungesättigte, durch Strahlung polymerisierbare Doppelbindung umfasst,
   c) 0 bis 20 Gew.-% eines Photoinitiators,
   d) 0 bis 60 Gew.-% eines Füllstoffs,
   e) 0 bis 20 Gew.-% weitere Zusatzstoffe,
   f) Wasser ad 100 Gew.-%,
ii) die aufgetragene Beschichtungsmasse durch Bestrahlung mit UV- oder Elektronenstrahlen härtet,
iii) mindestens einen weiteren strahlungshärtbaren Lack auf die beschichtete Oberfläche aufträgt und härtet.

### Komponente a):

Die im erfindungsgemäßen Verfahren eingesetzten, wässrigen, strahlungshärtbaren Beschichtungsmassen können als Komponente a) 5,0 bis 90,0 Gew.-%, bevorzugt 15 bis 85 Gew.-%, insbesondere 25 bis 85 Gew.-%, mindestens eines wasserdispergierbaren Polymerisats P enthalten.

Geeignete, wasserdispergierbare Polymerisate P, die wenigstens eine α,β-ethylenisch ungesättigte, strahlungshärtbare Doppelbindung umfassen, sind die Ester α,β-ethylenisch ungesättigter Monocarbonsäuren sowie die Ester von Halbestern α,β-ethylenisch ungesättigter Dicarbonsäuren mit Hydroxylgruppen-haltigen Polykondensaten Pk. Geeignete α,β-ethylenisch ungesättigte Monocarbonsäuren sind aliphatische C₃-C₆-Carbonsäuren, zum Beispiel Acrylsäure, Methacrylsäure, Crotonsäure, und Mischungen davon. Eine geeignete aromatische α,β-ungesättigte Carbonsäure ist Zimtsäure. Geeignete Halbester α,β-ethylenisch ungesättigter Dicarbonsäuren sind zum Beispiel die Malein-, Fumar- und Itaconsäurehalbester mit C₁-C₂₀-, bevorzugt C₁-C₈-Monoalkoholen, wie z. B. Methanol, Ethanol, n-Propanol, Isopropanol, n-Butanol, Isobutanol, t.-Butanol, 2-Ethylhexanol etc.

Geeignete Polykondensate Pk, die mindestens zwei freie Hydroxylgruppen pro Molekül enthalten, sind z. B. die üblichen, gegebenenfalls Ethergruppen enthaltenden Polyester bzw. gegebenenfalls Estergruppen enthaltenden Polyether. Geeignete Hydroxylgruppen-haltige Polyester können zum Beispiel in üblicher Weise durch Veresterung von zwei- oder mehrwertigen Carbonsäuren mit zwei- oder mehrwertigen Alkoholen hergestellt werden. Verfahren zur Herstellung von Polyestern sind dem Fachmann bekannt. Im allgemeinen werden als Carbonsäurekomponente für die Veresterung zur Herstellung von Hydroxylgruppen-haltigen Polyestern zwei- bis vierwertige, aliphatische und/oder aromatische C₃- bis C₃₆-Carbonsäuren, deren Ester und Anhydride eingesetzt. Dazu zählen zum Beispiel Bernsteinsäure, Bernsteinsäureanhydrid, Glutarsäure, Glutarsäureanhydrid, Adipinsäure, Pimelinsäure, Korksäure, Acelainsäure, Sebacinsäure, Phthalsäure, Phthalsäureanhydrid, Isophthalsäure, Terephthalsäure, Maleinsäure, Maleinsäureanhydrid, Fumarsäure, Citraconsäure, Tetrahydrophthalsäure, Tetrahydrophthalsäureanhydrid, Trimellithsäure, Trimellithsäureanhydrid, Pyromellithsäure und Pyromellithsäureanhydrid. Als Ausgangsstoffe für die Herstellung von Polyestern geeignete zwei- oder mehrwertige Alkohole sind zum Beispiel zwei- bis sechswertige Alkohole, z. B. Diole, wie Ethylenglykol, Propylenglykol, 1,4-Butandiol, 1,5-Pentandiol, Neopentylglykol, 1,6-Hexandiol, 2-Methyl-1,5-pentandiol, 2-Ethyl-1,4-butandiol, Dimethylolcyclohexan, Triole, wie Glycerin, Trimethylolethan, Trimethylolpropan, Trimethylolbutan, Tetraole, wie Pentaerythrit, Ditrimethylolpropan, Hexole, wie Erythrit und Sorbit. Weitere geeignete Polyesterole sind auch Polycaprolactondiole und -triole.

Weitere geeignete Hydroxylgruppen-haltige Polykondensate Pk sind die Alkoxilate der zuvor genannten zwei- oder mehrwertigen Alkohole. Dazu zählen zum Beispiel ethoxylierte, propoxylierte und gemischt ethoxylierte und propoxylierte zwei- bis sechswertige Alkohole und Polyesterole. Der Alkoxylierungsgrad liegt dabei in der Regel bei 1 bis 300, bevorzugt bei 2 bis 150.

Weitere geeignete Polykondensate Pk sind Polyalkylenglykole bzw. die Polyadditionspolymerisate von cyclischen Ethern, wie z. B. Polytetrahydrofuran. Beispiele für Polyalkylenglykole sind Polyethylenglykol, Polypropylenglykol und Polyepichlorhydrine.

Des weiteren geeignete Polykondensate Pk sind auch Copolymerisate, die wenigstens eine der zuvor genannten monomeren, oligomeren oder polymeren Komponenten einpolymerisiert enthalten. Dazu zählen z. B. Polyester der zuvor genannten zwei- oder mehrwertigen Carbonsäuren und Alkohole mit terminalen Carboxylgruppen oder Hydroxylgruppen und Polyetherole, wie die zuvor genannten Alkoxilate, Polyalkylenglykole und Polymerisate cyclischer Ether.

Zur Herstellung der erfindungsgemäß als Komponente a) eingesetzten Polymerisate P können die zuvor genannten, α,β-ethylenisch ungesättigten Monocarbonsäuren und Dicarbonsäurehalbester mit den oben genannten Polykondensaten Pk nach üblichen Verfahren verestert werden. Die Entfernung des bei der Veresterungsreaktion gebildeten Reaktionswassers kann dabei zum Beispiel durch wasserentziehende Mittel, extraktiv oder durch azeotrope Destillation erfolgen. Die Veresterung erfolgt im allgemeinen im Gegenwart eines Katalysators, z. B. einer starken Säure, wie Schwefelsäure, wasserfreier Chlorwasserstoff, Sulfonsäuren, z. B. Toluolsulfonsäure und sauren Ionenaustauschern. Zur Vermeidung einer vorzeitigen Polymerisation erfolgt die Veresterung vorzugsweise in Gegenwart eines Polymerisationsinhibitors, der zur Verhinderung einer thermischen Polymerisation der erfindungsgemäß eingesetzten Polymerisate P geeignet ist.

Weitere geeignete Komponenten a) sind die Ether α,β-ethylenisch ungesättigter Alkohole mit den zuvor genannten Polykondensaten Pk. Diese enthalten als α,β-ethylenisch ungesättigte Alkoholkomponente z. B. Allylalkohol, Methallylalkohol, Crotylalkohol, Zimtalkohol, und Mischungen davon. Die Veretherung zur Herstellung von als Komponente a) geeigneten Polymerisaten P erfolgt nach üblichen, dem Fachmann bekannten Verfahren.

Weitere geeignete Komponenten a) sind Epoxidharzderivate, die α,β-ethylenische Doppelbindungen enthalten. Als Polymerisate P geeignete Epoxidharzderivate sind die Reaktionsprodukte aus den zuvor genannten α,β-ethylenisch ungesättigten Monocarbonsäuren und Dicarbonsäurehalbestern mit oligomeren oder polymeren Komponenten, die durchschnittlich mindestes zwei Epoxidgruppen pro Molekül enthalten. Dazu zählen zum Beispiel die Polyglycidylether der zuvor genannten mehrwertigen Alkohole, Polyglycidylether kondensierter Phenole, z. B. Bisphenol A, Glycidylester der zuvor genannten, mehrwertigen Carbonsäuren, weitere Glycidylverbindungen, wie z. B. Triglycidylisocyanurat, sowie epoxidierte, natürliche oder synthetische Öle, und Mischungen davon. Verfahren zur Umsetzung von Carbonsäuren mit Epoxiden sind dem Fachmann bekannt.

Weitere geeignete Komponenten a) sind Polyurethanderivate, die α,β-ethylenisch ungesättigte Doppelbindungen enthalten. Diese sind zum Beispiel erhältlich durch Umsetzung von Isocyanat-terminierten Polyurethanen mit Hydroxylgruppen-haltigen Estern der zuvor genannten, α,β-ethylenisch ungesättigten Monocarbonsäuren, wie (Meth)acrylsäureestern, z. B. Hydroxyethyl(meth)acrylat, Hydroxypropyl(meth)acrylat, Butandiolmono(meth)acrylat etc. Isocyanatterminierte Polyurethane werden durch Umsetzung von aliphatischen und/oder aromatischen Di- und Polyisocyanaten und deren Di- oder Trimeren mit Verbindungen, die aktive Wasserstoffatome aufweisen, wie z. B. die zuvor genannten, mehrwertigen Alkohole, polyfunktionellen Aminen und/oder Aminoalkoholen erhalten. Beim Einsatz von Aminen und/oder Aminoalkoholen resultieren Polyurethane, die Harnstoffgruppen umfassen. Das Verhältnis von Isocyanat-terminierten zu anders terminierten Polyurethanen wird über das Molmengenverhältnis der Edukte gesteuert.

Für das erfindungsgemäße Verfahren besonders geeignete, wasserdispergierbare, strahlungshärtbare Polyurethane und deren Dispersionen werden in der EP-A-0704 469 beschrieben, auf die hiermit in vollem Umfang Bezug genommen wird. Diese beschreibt ein wasserdispergierbares, strahlungshärtbares Polyurethan, im wesentlichen aufgebaut aus
(1) organischen Polyisocyanaten,
(2) Polyesterpolyolen
(3) gegebenenfalls von (2) verschiedenen Polyolen
(4) Verbindungen mit mindestens einer gegenüber Isocyanat reaktiven Gruppe und mindestens einer Carboxylgruppe oder Carboxylatgruppe
(5) Verbindungen mit mindestens einer gegenüber Isocyanat reaktiven Gruppe und mindestens einer copolymerisierbaren, ungesättigten Gruppe,
(6) gegebenenfalls von (1) bis (5) verschiedenen Verbindungen mit mindestens einer gegenüber Isocyanat reaktiven Gruppe.

Als Polyisocyanate (1) kommen z. B. geradkettige oder verzweigte C₄-C₁₄-Alkylendiisocyanate, cycloaliphatische Diisocyanate mit insgesamt 6 bis 12 C-Atomen, aromatische Diisocyanate mit insgesamt 8 bis 14 C-Atomen, Isocyanuratgruppen aufweisende Polyisocyanate, Uretdiondiisocyanate, Biuretgruppen aufweisende Polyisocyanate, Urethan- und/oder Allophanatgruppen aufweisende Polyisocyanate, Oxadiazintriongruppen enthaltende Polyisocyanate, Uretonimin-modifizierte Polyisocyanate oder deren Gemische in Betracht.

Als Diisocyanate genannt seien z. B. Tetramethylendiisocyanat, Hexamethylendiisocyanat(1,6-Diisocyanatohexan), Octamethylendiisocyanat, Decamethylendiisocyanat, Dodecamethylendiisocyanat, Tetradecamethylendiisocyanat, Trimethylhexandiisocyanat oder Tetramethylhexandiisocyanat, cycloaliphatische Diisocyanate wie 1,4-, 1,3- oder 1,2-Diisocyanatocyclohexan, 4,4'-Di(isocyanatocyclohexyl)methan, 1-Isocyanato-3,3,5-trimethyl-5-(isocyanatomethyl)cyclohexan (Isophorondiisocyanat) oder 2,4- oder 2,6-Diisocyanato-1-methylcyclohexan oder aromatische Diisocyanate wie 2,4-Diisocyanatotoluol, 2,6-Diisocyanatotoluol, Tetramethylxylylendiisocyanat, 1,4-Diisocyanatobenzol, 4,4'- und 2,4-Diisocyanatodiphenylmethan, p-xylylendiisocyanat sowie Isopropenyldimethyltoluylendiisocyanat.

Bei den Isocyanuratgruppen aufweisenden Polyisocyanaten handelt es sich insbesondere um einfache Tris-isocyanato-Isocyanurate, welche cyclische Trimere der Diisocyanate darstellen, oder um Gemische mit ihren höheren, mehr als einen Isocyanuratring aufweisenden Homologen.

Bei Uretdiondiisocyanaten handelt es sich bevorzugt um cyclische Dimerisierungsprodukte von Diisocyanaten. Die Uretdiondiisocyanate können z. B. als alleinige Komponente oder im Gemisch mit anderen Polyisocyanaten, insbesondere den Isocyanuratgruppen enthaltenden Polyisocyanaten genannten, eingesetzt werden. Geeignete Biuretgruppen aufweisende Polyisocyanate weisen vorzugsweise einen NCO-Gehalt von 18 bis 22 Gew.-% und eine mittlere NCO-Funktionalität von 3 bis 4,5 auf.

Urethan- und/oder Allophanatgruppen aufweisende Polyisocyanate können beispielsweise durch Umsetzung von überschüssigen Mengen an Diisocyanaten mit einfachen, mehrwertigen Alkoholen, wie z. B. Trimethylolpropan, Glycerin, 1,2-Dihydroxypropan oder deren Gemischen erhalten werden. Diese Urethan- und/oder Allophanatgruppen aufweisenden Polyisocyanate haben im allgemeinen einen NCO-Gehalt von 12 bis 20 Gew.-% und eine mittlere NCO-Funktionalität von 2,5 bis 3.

Oxadiazintriongruppen enthaltende Polyisocyanate sind aus Diisocyanat und Kohlendioxid herstellbar.

Bei den Polyesterpolyolen (2) handelt es sich insbesondere um Polyesterdiole. Geeignete Polyesterpolyole sind die zuvor als Komponente Pk genannten.

Bei den weiteren Polyolen (3) handelt es sich z. B. um niedermolekulare Diole oder auch Triole, insbesondere mit einem Molekulargewicht unter 500 g/mol, welche als Kettenverlängerer oder Vernetzer Verwendung finden.

Als weitere Aufbaukomponente (4) werden Verbindungen eingesetzt, die mindestens eine, vorzugsweise eine oder zwei gegenüber Isocyanatgruppen reaktionsfähige Gruppen, also Hydroxyl-, primäre oder sekundäre Aminogruppen, und mindestens eine Carboxyl- oder Carboxylatgruppe enthalten.

Genannt seien z. B. Hydroxycarbonsäuren, z. B. Dihydroxycarbonsäuren, wie Dimethylolpropionsäure, sulfonsäurehaltige Carbonsäuren, z. B. 5-Sulfoisophthalsäure, oder Aminocarbonsäuren. Bevorzugt sind Aminocarbonsäuren, besonders bevorzugt Diaminocarbonsäuren. Ganz besonders bevorzugt sind Addukte von Acrylsäure an C₂-C₆-, vorzugsweise C₂-Alkylendiamine im Molverhältnis Alkylendiamin:Acrylsäure von vorzugsweise ca. 1:1 (PUD-Salz).

Durch die Aufbaukomponente (4) werden die Polyurethane selbst dispergierbar, d. h. beim Dispergieren in Wasser werden in diesem Fall im allgemeinen keine Dispergierhilfsmittel wie Schutzkolloide oder Emulgatoren benötigt.

Carboxylgruppen werden vor oder bei der Dispergierung in Wasser z. B. durch anorganische und/oder organische Basen, wie Alkalihydroxyde, -carbonate, -hydrogencarbonate, Ammoniak oder primäre, sekundäre oder vorzugsweise tertiäre Amine wie Triethylamin neutralisiert.

Als Aufbaukomponente (5), welche mindestens eine copolymerisierbare, ungesättigte Gruppe, und mindestens eine, vorzugsweise eine gegenüber Isocyanat reaktive Gruppe aufweisen, kommen z. B. Ester von Acryl- oder Methacrylsäure mit Polyolen in Betracht, wobei mindestens eine Hydroxylgruppe unverestert bleibt. Besonders bevorzugt sind C₁-C₁₂-Hydroxylalkyl(meth)acrylate, wobei die Alkylketten linear oder verzweigt sein können.

Bei den gegebenenfalls einzusetzenden Aufbaukomponenten (6) handelt es sich z. B. um mindestens difunktionelle Amin-Kettenverlängerer bzw. -vernetzer, vorzugsweise des Molekulargewichtsbereiches von 32 bis 500 g/mol, welche mindestens zwei primäre, zwei sekundäre oder eine primäre und eine sekundäre Aminogruppe enthalten.

Beispiele hierfür sind Diamine, wie Diaminoethan, Diaminopropane, Diaminobutane, Diaminohexane, Piperazin, 2,5-Dimethylpiperazin, Amino-3-aminomethyl-3,5,5-trimethyl-cyclohexan (Isophorondiamin, IPDA), 4,4'-Diaminodicyclohexylmethan, 1,4-Diaminocyclohexan, Aminoethylethanolamin, Hydrazin, Hydrazinhydrat oder Triamine, wie Diethylentriamin oder 1,8-Diamino-4-aminomethyloctan.

Weitere geeignete Komponenten a) sind α,β-ethylenische Doppelbindungen enthaltende Polymerisate P aus Polymeren, welche freie Hydroxyl-, Carboxyl- und/oder Epoxygruppen enthalten, die mit Verbindungen mit α,β-ethylenisch ungesättigten Doppelbindungen, wie zum Beispiel den zuvor genannten α,β-ethylenisch ungesättigten Monocarbonsäuren, umgesetzt werden können. Dadurch werden Polymere mit α,β-ethylenisch ungesättigten Acylresten erhalten.

Besonders bevorzugte Komponenten a) werden in der EP-A-00 12 339 beschrieben, auf die hiermit in vollem Umfang Bezug genommen wird.

Das Polymerisat P kann als Polymerisatpulver oder als Polymerdispersion Pd zugegeben werden.

Geeignete Polymerdispersionen Pd sind sowohl Primärdispersionen, bei welchen die Polymerisation der Monomere direkt in der flüssigen Phase erfolgt (Suspensions- oder Emulsionspolymerisation), als auch Sekundärdispersionen, bei welchen vorgefertigte Polymere in einem weiteren Verfahrensschritt dispergiert werden.

Zur Herstellung von Sekundärdispersionen Pd der erfindungsgemäß eingesetzten Polymerisate P können diese als Feststoff oder als Lösung in einem inerten, organischen Lösungsmittel mit der wässrigen Phase gemischt werden. Vorzugsweise wird das Polymerisat P als Lösung in einem inerten, organischen Lösungsmittel oder Lösungsmittelgemisch eingesetzt. Dabei kann auch eine direkt bei der Synthese der Polymerisate P anfallende Lösung eingesetzt werden. Geeignete organische Lösungsmittel sind z. B. Tetrahydrofuran, Dioxan, Aceton, Methylethylketon, Alkohole, wie n-Propanol, Isopropanol, n-Butanol, Isobutanol, Ester, wie Ethylacetat und Butylacetat, aromatische Kohlenwasserstoffe, wie Toluol und Xylole, wobei inerte, mit Wasser mischbare Lösungsmittel, wie Aceton, Tetrahydrofuran, Methylethylketon und Alkohole bevorzugt sind.

Das Polymerisat P oder dessen Lösung wird zur Herstellung der Dispersionen Pd mit einer geeigneten, z. B. dem gewünschten Feststoffgehalt der Dispersion entsprechenden Menge Wasser und gegebenenfalls mindestens einem Dispergiermittel sowie, gegebenenfalls weiterer Zusatzstoffe gemischt. Geeignete Apparaturen zum Mischen und gegebenenfalls zum destillativen Abtrennen des organischen Lösungsmittels sind dem Fachmann bekannt.

Der Zusatz von wenigstens einem Dispergierhilfsmittel zu den Polymerdispersionen Pd ist abhängig von den eingesetzten Polymerisaten P. Aus der EP-A-0 704 469 sind wasserdispergierbare, strahlungshärtbare Polyurethane bekannt, die eine Aufbaukomponente enthalten, die sie selbstdispergierbar machen. Beim Einsatz dieser Polyurethane kann daher im allgemeinen auf Dispergierhilfsmittel, wie Schutzkolloide oder Emulgatoren, verzichtet werden.

Bei Verwendung anderer Polymerisate P als der zuvor genannten Polyurethane können den wässrigen Polymerdispersionen Pd Emulgatoren und/oder Schutzkolloide in einer Menge von im allgemeinen etwa 0,05 bis 20 Gew.-%, bevorzugt 0,1 bis 15 Gew.-%, bezogen auf die Menge des Polymerisats P zugesetzt werden.

Geeignete Emulgatoren sind die dem Fachmann bekannten, üblicherweise bei der wässrigen Emulsionspolymerisation als Dispergiermittel eingesetzten Emulgatoren, wie sie z. B. in Houben-Weyl, Methoden der organischen Chemie, Band XIV/1, Makromolekulare Stoffe, Georg-Thieme-Verlag, Stuttgart, 1961, S. 411 - 420 beschrieben sind. Es sind sowohl anionische, kationische als auch nichtionische Emulgatoren geeignet. Vorzugsweise werden Emulgatoren eingesetzt, deren relative Molekulargewichte im Unterschied zu Schutzkolloiden üblicherweise unter 3500 Dalton liegen.

Brauchbare nichtionische Emulgatoren sind araliphatische oder aliphatische nichtionische Emulgatoren, beispielsweise ethoxylierte Mono-, Di- und Trialkylphenole (EO-Grad: 3 bis 50, Alkylrest: C₄-C₁₀), Ethoxylate langkettiger Alkohole (EO-Grad: 3 bis 50, Alkylrest: C₈-C₃₆) sowie Polyethylenoxid/Polypropylenoxid-Blockcopolymere. Bevorzugt werden Ethoxylate langkettiger Alkanole (Alkylrest C₁₀-C₂₂, mittlerer Ethoxylierungsgrad 10 bis 50) und darunter besonders bevorzugt solche mit einem linearen C₁₂-C₁₈-Alkylrest und einem mittleren Ethoxylierungsgrad von 10 bis 50 sowie ethoxylierte Monoalkylphenole.

Geeignete anionische Emulgatoren sind beispielsweise Alkali- und Ammoniumsalze von Alkylsulfaten (Alkylrest: C₈-C₂₂), von Schwefelsäurehalbestern ethoxylierter Alkanole (EO-Grad: 2 bis 50, Alkylrest: C₁₂-C₁₈) und ethoxylierter Alkylphenole (EO-Grad: 3 bis 50, Alkylrest: C₄-C₉), von Alkylsulfonsäuren (Alkylrest: C₁₂-C₁₈) und von Alkylarylsulfonsäuren (Alkylrest: C₉-C₁₈). Weitere geeignete Emulgatoren finden sich in Houben-Weyl, Methoden der organischen Chemie, Band XIV/1, Makromolekulare Stoffe, Georg-Thieme-Verlag, Stuttgart, 1961, S. 192 - 208). Als anionische Emulgatoren sind ebenfalls Bis(phenoylsulfonsäure)ether bzw. deren Alkali- oder Ammoniumsalze, die an einem oder beiden aromatischen Ringen eine C₄-C₂₄-Alkylgruppe tragen, geeignet. Diese Verbindungen sind allgemein bekannt, z. B. aus der US-A-4,269,749, und im Handel erhältlich, beispielsweise als Dowfax® 2A1 (Dow Chemical Company).

Geeignete kationische Emulgatoren sind vorzugsweise quartäre Ammoniumhalogenide, z. B. Trimethylcetylammoniumchlorid, Methyltrioctylammoniumchlorid, Benzyltriethylammoniumchlorid oder quartäre Verbindungen von N-C₆-C₂₀-Alkylpyridinen, -morpholinen oder - imidazolen, z. B. N-Laurylpyridiniumchlorid.

Geeignete Schutzkolloide sind z. B. Polyvinylalkohole und teilverseifte Polyvinylacetate, Polyvinylpropionate, Polyacrylate, Polyvinylpyrrolidon, Copolymere aus zwei oder mehrerender die zuvorgenannten Polymere bildenden Monomeren, Cellulose und Cellulosederivate, wie z. B. Methylcellulose, Hydroxyethylcellulose, Carboxymethylcellulose, Stärke und Stärkederivate, wie z. B. Cyanalkyletherstärke, Hydroxyalkyletherstärke und Carboxymethylstärke, Proteine und Proteinabbauprodukte, wie z. B. Gelatine und Gelatinederivate etc. Eine ausführliche Beschreibung von Schutzkolloiden findet sich in Houben-Weyl, Methoden der Organischen Chemie, Band XIV/1, Makromolekulare Stoffe, Georg-Thieme-Verlag, Stuttgart, 1961, S. 411 - 420.

Weitere geeignete Zusatzstoffe der Polymerdispersionen Pd sind die im folgenden beschriebenen Komponenten c), d) und e) der im erfindungsgemäßen Verfahren eingesetzten Beschichtungsmassen, die bei Einsatz einer wässrigen Polymerdispersion Pd bereits dieser in den angegebenen Mengen zugegeben werden können.

Der Zusatz der Dispergierhilfsmittel und/oder der Zusatzstoffe kann einzeln oder als Mischung zu der organischen Phase, der wässrigen Phase oder der Mischung aus organischer und wässriger Phase erfolgen.

Wird das Polymerisat P zur Herstellung der Dispersionen Pd in einem organischen Lösungsmittel eingesetzt, so kann dieses nach Mischen mit der wässrigen Phase und gegebenenfalls den zuvor beschriebenen Zusätzen destillativ abgetrennt werden. Die Destillation kann bei Normaldruck oder unter vermindertem Druck erfolgen. Je nach eingesetztem, organischen Lösungsmittel kann dabei ein Teil des Wassers als azeotropes Gemisch mit entfernt werden. Gegebenenfalls ist dann im Anschluß an die Destillation ein Zusatz von Wasser zur Erzielung des gewünschten Feststoffgehaltes der Dispersion erforderlich. Das organische Lösungsmittel wird im wesentlichen vollständig entfernt, wobei der Restlösungsmittelgehalt im allgemeinen unter 0,1 Gew.-%, bezogen auf die Gesamtmenge der wässrigen Beschichtungsmasse, liegt.

### Komponente b):

Die im erfindungsgemäßen Verfahren eingesetzten wässrigen, strahlungshärtbaren Beschichtungsmassen enthalten als Komponente b) 0,1 bis 90 Gew.-%, bevorzugt 10 bis 85 Gew.-%, mindestens einer, von P verschiedenen, wasserlöslichen oder wasserverdünnbaren, strahlungshärtbaren Verbindung S, die wenigstens eine α,β-ethylenisch ungesättigte, strahlungshärtbare Doppelbindung umfasst.

Geeignete Verbindungen S sind aliphatische und aromatische Epoxidacrylate und Epoxidmethacrylate, wobei bevorzugt aliphatische Verbindungen eingesetzt werden. Dazu zählen zum Beispiel die zuvor bereits als Polymerisate P beschriebenen Umsetzungsprodukte der Acrylsäure oder Methacrylsäure mit aliphatischen Glycidylethern. Bevorzugt werden als Glycidylether Butandioldiglycidether, Pentandioldiglycidether, Hexandioldiglycidether, Phenylglycidether etc. eingesetzt, die als Grilonit® RV-Marken der Fa. Ems erhältlich sind.

Weitere geeignete Verbindungen S sind Polyetheracrylate und - methacrylate, Polyesteracrylate und -methacrylate sowie Polyurethanacrylate und -methacrylate. Geeignete Verbindungen dieses Typs sind die entsprechenden, als Komponente a) beschriebenen Po-lymerisate P. Bevorzugt sind dabei die Umsetzungsprodukte der Acrylsäure oder Methacrylsäure mit den als Polykondensate Pk beschriebenen Polyesterolen und Polyetherolen. Insbesondere bevorzugt sind die in der EP-A-126 341 und EP-A-279303 beschriebenen, strahlungshärtbaren Acrylate, auf die hiermit in vollem Umfang Bezug genommen wird. Als Polyetherole werden dabei bevorzugt alkoxylierte, insbesondere ethoxylierte und/oder propoxylierte, mono-, di-, tri- oder polyfunktionelle Alkohole eingesetzt.

Weitere geeignete Verbindungen S sind Melaminacrylate und Methacrylate. Diese werden z. B. durch Veresterung der freien Methylolgruppen der Harze mit Acrylsäure oder Methacrylsäure oder durch Umetherung veretherter Melaminverbindungen mit Hydroxyalkylmethacrylaten, z. B. Hydroxyethyl(meth)acrylat, Hydroxypropyl(meth)acrylat und Hydroxybutyl(meth)acrylat, erhalten.

Weitere geeignete Verbindungen S sind allgemein Verdicker, die ungesättigte Gruppen enthalten. Dazu zählen zum einen Polyurethanverdicker, die durch Einbau der zuvor genannten Hydroxyalkyl(meth)acrylate α,β-ethylenisch ungesättigte Doppelbindungen enthalten. Dazu zählen weiterhin Polyacrylatverdicker, die durch polymeranaloge Umsetzung von z.B. säure- oder hydroxylgruppenhaltigen Polymeren mit epoxidhaltigen (Meth)acrylaten, wie z.B. Glycidyl(meth)acrylat, oder von hydroxylgruppenhaltigen Polymeren durch Veresterung mit (Meth)acrylsäure oder Umsetzung mit (Meth)acrylsäureanhydrid, oder durch Umsetzung mit NCO-terminierten (Meth)acrylaten, wie z.B. Methacryloylisocyanat, Isocyanatoethyl(meth)acrylat, etc., erhalten werden. Dazu zählen weiterhin Polyvinylalkohole, die z.B. durch Umsetzung mit (Meth)acrylsäureanhydrid oder durch Veresterung mit (Meth)acrylsäure mit Doppelbindungen enthaltenden Gruppen modifiziert werden. Dazu zählen schließlich Copolymere, welche Maleinsäureanhydrid als Comonomeres enthalten, wobei das Polymer durch Ringöffnung des Anhydrids mit den zuvor genannten Hydroxyalkyl(meth)acrylaten oder mit Hydroxyvinylethern, wie z.B. Butandiolmonovinylether, Cyclohexandimethanolmonovinylether, etc., mit Doppelbindungen modifiziert wird.

Die Verbindungen S werden den im erfindungsgemäßen Verfahren eingesetzten wässrigen, strahlungshärtbaren Beschichtungsmassen in einer solchen Menge zugesetzt, dass diese einen Feststoffgehalt im Bereich von 50 bis 95 Gew.-% erreichen. Nach einer bevorzugten Ausführungsform des erfindungsgemäßen Verfahrens handelt es sich um Beschichtungsmassen, bei denen:
I) das Polymerisat P ein Ester α,β-ethylenisch ungesättigter Monocarbonsäuren mit Hydroxylgruppen-haltigen Polykondensaten Pk und die Verbindung S ein Epoxidacrylat, Epoxidmethacrylat, Polyetheracrylat oder Polyethermethacrylat ist, oder
II) das Polymerisat P ein α,β-ethylenische Doppelbindungen enthaltendes Polyurethanderivat und die Verbindung S ein Polyurethanverdicker mit α,β-ethylenisch ungesättigten, durch Strahlung polymerisierbaren Doppelbindungen ist, oder
III) das Polymerisat P ein α,β-ethylenische Doppelbindungen enthaltendes Polyurethanderivat und die Verbindung S ein Verdicker auf Acrylatbasis mit α,β-ethylenisch ungesättigten, durch Strahlung polymerisierbaren Doppelbindungen ist, oder
IV) das Polymerisat P ein Ester α,β-ethylenisch ungesättigter Monocarbonsäuren mit Hydroxylgruppen-haltigen Polykondensaten Pk und die Verbindung S ein Melaminacrylat oder Melaminmethacrylat ist.

### Komponente c):

Die im erfindungsgemäßen Verfahren eingesetzten Beschichtungsmassen können zur Strahlungshärtung energiereicher Elektronenstrahlung oder UV-Strahlung ausgesetzt werden. Erfolgt die Härtung durch UV-Strahlung, so wird den Beschichtungsmassen als Komponente c) 0,05 bis 20 Gew.-%, bevorzugt 0,05 bis 10 Gew.-%, insbesondere 0,1 bis 5 Gew.-% eines Photoinitiators zugesetzt.

Geeignete Photoinitiatoren werden in P.K.T Oldring, Chemistry & Technology of UV & EB Formulation for Coatings, Inks & Paints, SITA Technology, London 1991, Volume 3, Photoinitiators for Free Radical and Cationic Polymerisation, beschrieben.

Dazu zählen z. B. Benzophenon, Alkylbenzophenone, wie 4-Methylbenzophenon, halogenmethylierte Benzophenone, Michlers Keton (4,4'-Bisdimethylamin-benzophenon), halogenierte Benzophenone, wie 4-Chlorbenzophenon, 4,4'-Dichlorbenzophenon, Anthrachinon, Anthron (9,10-Dihydro-9-anthracenon), Benzoin, Isobutylbenzoinether, Benzil und Benzilderivate, wie z.B. Benzildimethylketal, Phosphinoxide oder Phosphinsulfide, wie Bisacylphosphinoxide, 2,4,6-Trimethylbenzoyldiphenylphosphinoxid, etc.

Gewünschtenfalls können die im erfindungsgemäßen Verfahren eingesetzten Beschichtungsmassen zusätzlich einen Synergisten, bevorzugt ein tertiäres Amin, enthalten. Geeignete Synergisten sind z. B. Triethylamin, Dimethylethanolamin, Methyldiethanolamin, Triethanolamin, Aminoacrylate, z. B. aminmodifizierte Polyetheracrylate, wie die BASF Laromer®-Marken LR 8956, LR 8889, LR 8869, LR 8894, PO 83F und PO 84F, und Mischungen davon. Sie werden bei reinen tert. Aminen im allgemeinen in einer Menge bis zu 5 Gew.-%, bei Aminoacrylaten einem bezogen auf die Anzahl enthaltener Aminogruppen dementsprechenden Äquivalent, bezogen auf die Gesamtmenge der Beschichtungsmassen, eingesetzt.

### Komponente d):

Die Beschichtungsmassen können weiterhin etwa 0 bis 60 Gew.-%, bevorzugt etwa 5 bis 50 Gew.-% eines Füllstoffes enthalten. Geeignete Füllstoffe sind z. B. Silikate, die durch Hydrolyse von Siliciumtetrachlorid erhältlich sind (Aerosil® der Fa. Degussa), Kieselerde, Talkum, Aluminiumsilikate, Magnesiumsilikate, etc.

### Komponente e):

Die Beschichtungsmassen können weiterhin 0 bis 20 Gew.-% weitere Zusatzstoffe enthalten. Geeignete weitere Zusatzstoffe sind die bereits bei den wässrigen Polymerdispersionen Pd der Komponente a) genannten Emulgatoren und Schutzkolloide.

Weitere Zusätze, die die Beschichtungsmassen enthalten können, sind übliche, dem Fachmann bekannte Zusätze, wie z. B. Mattierungsmittel, Pigmente, Verlaufshilfsmittel, Entschäumer etc. Sie können unter Anwendung von üblichen Methoden in die fertigen Dispersionen eingearbeitet werden.

Die im erfindungsgemäßen Verfahren eingesetzten Beschichtungsmassen weisen vorteilhafterweise einen Feststoffgehalt von mindestens 50 Gew.-%, bevorzugt mindestens 65 Gew.-%, insbesondere mindestens 70 Gew.-% und besonders bevorzugt mindestens 75 Gew.-%, auf. Im allgemeinen weisen die Beschichtungsmassen einen Feststoffgehalt von nicht mehr als 95 Gew.-% auf.

Die aus dem Stand der Technik bekannten strahlungshärtbaren Beschichtungsmassen müssen nach Auftrag auf das Substrat vor der Bestrahlung mit UV- oder Elektronenstrahlen im allgemeinen physi- . kalisch getrocknet werden. Dazu werden die Beschichtungsmassen im allgemeinen bis zu 30 Minuten bei Temperaturen bis zu 100 °C vorgeheizt und anschließend kurzzeitig einer UV- oder energiereichen Elektronenstrahlung ausgesetzt. Bei den im erfindungsgemäßen Verfahren eingesetzten Beschichtungsmassen kann vorteilhafterweise in Abhängigkeit vom Auftragsgewicht ab einem Feststoffgehalt von etwa 65 Gew.-%, bevorzugt ab einem Feststoffgehalt von etwa 75 Gew.-%, bei saugfähigen Substraten auf die physikalische Trocknung verzichtet werden. Die Beschichtungsmassen können dann nach dem Auftragen auf das Substrat durch Bestrahlung angeliert oder gegebenenfalls durchgehärtet werden und danach mit einem üblichen strahlungshärtbaren Lackaufbau beschichtet und gehärtet werden. Sie können gewünschtenfalls aber auch ohne Angelieren und Härten direkt überlackiert werden. Die Beschichtungsmassen können dabei durch übliche Verfahren, wie z. B. Spritzen, Gießen oder Walzen auf die Oberfläche aufgebracht werden.

Die Herstellung der im erfindungsgemäßen Verfahren eingesetzten wässrigen, strahlungshärtbaren Beschichtungsmassen erfolgt durch Dispergieren der zuvor genannten Einzelkomponenten nach üblichen Verfahren. Dazu können die Komponenten a), b), c), d) und e) einzeln oder als Mischungen, fest oder gelöst bzw. vordispergiert in einer entsprechenden Menge Wasser gemischt und z. B. unter Rühren dispergiert werden. Wird eine wässrige Polymerdispersion Pd eingesetzt; so können auch einzelne oder mehrere Komponenten dieser Dispersion zugegeben und anschließend gewünschtenfalls mit Wasser auf den angestrebten Feststoffgehalt verdünnt werden. Geeignete Verfahren und Apparaturen zur Herstellung der im erfindungsgemäßen Verfahren eingesetzten Beschichtungsmassen sind dem Fachmann bekannt.

Die vorliegenden Dispersionen sind im wesentlichen frei von organischen Lösungsmitteln und weisen eine hohe Lagerstabilität auf. Sie eignen sich gut als Beschichtungsmassen für alle üblichen strahlungshärtbaren Lacke, wie für solche auf Basis wässriger und nichtwässriger Dispersionen. Dabei können mit ihnen nichtsaugende Substrate, wie zum Beispiel Kunststoffe, Textilsynthesefasern, Glas und bevorzugt Metalle beschichtet werden. Bevorzugt eignen sich die im erfindungsgemäßen Verfahren eingesetzten Beschichtungsmassen zur Beschichtung von saugenden Substraten, wie z. B. Papier, Leder, Textil, Holz und Holzwerkstoffen, wie z. B. Spanplatten. Vorteilhafterweise werden dabei auch bei verschiedenen tropischen Hölzern, wie z. B. Teak, Meerbaum, Mahagoni etc., auf denen Lacke ohne Grundierung sowie auch übliche Beschichtungsmassen schlecht haften, gut haftende Beschichtungen erzielt.

Ein weiterer Gegenstand der vorliegenden Erfindung sind wässrige, strahlungshärtbare Beschichtungsmassen, enthaltend:
a) 5,0 bis 90,0 Gew.-% mindestens eines wasserdispergierbaren Polymerisats P, umfassend wenigstens eine α,β-ethylenisch ungesättigte, durch Strahlung polymerisierbare Doppelbindung, wobei das Polymerisat P ausgewählt ist unter Estern α,β-ethylenisch ungesättigter Monocarbonsäuren mit Hydroxylgruppen-haltigen Polykondensaten Pk, Estern α,β-ethylenisch ungesättigter Dicarbonsäurehalbester mit Polykondensaten Pk, Ethern α,β-ethylenisch ungesättigter Alkohole mit Polykondensaten Pk, α,β-ethylenische Doppelbindungen enthaltenden Epoxidharzderivaten, sowie Polymeren mit sich wiederholenden Einheiten, die Acylreste mit α,β-ethylenischen Doppelbindungen enthalten, und Mischungen davon,
b) 0,1 bis 90 Gew.-% mindestens einer von P verschiedenen, wasserlöslichen oder mit mindestens 10 Gew.-% Wasser, bezogen auf das Gesamtgewicht der Beschichtungsmasse, verdünnbaren, strahlungshärtbaren Verbindung S, die wenigstens eine α,β-ethylenisch ungesättigte, durch Strahlung polymerisierbare Doppelbindung umfasst, wobei die Verbindung S ausgewählt ist unter Epoxidacrylaten, Epoxidmethacrylaten, Polyetheracrylaten, Polyethermethacrylaten, Polyesteracrylaten, Polyestermethacrylaten, Melaminacrylaten, Melaminmethacrylaten, Verdikkern, und Mischungen davon,
c) 0 bis 20 Gew.-% eines Photoinitiators,
d) 0 bis 60 Gew.-% eines Füllstoffs,
e) 0 bis 20 Gew.-% weitere Zusatzstoffe,
f) Wasser ad 100 Gew.-%.

Das Polykondensat Pk ist ausgewählt unter Polyestern, die gegebenenfalls Ethergruppen enthalten, Polyethern, die gegebenenfalls Estergruppen enthalten, Alkoxilaten zwei- oder mehrwertiger Alkohole, Polyalkylenglykolen, Polyadditionspolymerisaten cyclischer Ether, und Mischungen und Copolymerisaten davon.

Nach einer bevorzugten Ausführungsform handelt es sich um Beschichtungsmassen, bei denen
I) das Polymerisat P ein Ester α,β-ethylenisch ungesättigter Monocarbonsäuren mit Hydroxylgruppen-haltigen Polykondensaten Pk und die Verbindung S ein Epoxidacrylat, Epoxidmethacrylat, Polyetheracrylat oder Polyethermethacrylat ist, oder
II) das Polymerisat P ein Ester α,β-ethylenisch ungesättigter Monocarbonsäuren mit Hydroxylgruppen-haltigen Polykondensaten Pk und die Verbindung S ein Melaminacrylat oder Melaminmethacrylat ist.

Die Erfindung wird anhand der folgenden, nicht einschränkenden Beispiele näher erläutert.

### Beispiele

### Beispiel 1:

In 33 Teile einer 50%igen Polyesteracrylatemulsion (Laromer® LR 8895 der Fa. BASF AG) werden 67 Teile eines aliphatischen Epoxidacrylates (Laromer® LR 8765 der Fa. BASF AG) eindispergiert und mit 1 % eines Photoinitiatorgemisches aus Benzophenon und 1-Hydroxycyclohexylphenylketon im Gewichtverhältnis 1:1 (Irgacure® 500, Photoinitiator der Fa. Ciba) versetzt. Es wird eine stabile Lösung erhalten. Der Feststoffgehalt liegt bei etwa 83 %. Diese Beschichtungsmasse wird als Primer in einer Schichtstärke von ca. 10 g/m² auf eine Buchenoberfläche aufgewalzt und mit einem Strahler (120 W/cm) angeliert. Danach wird eine übliche strahlungshärtbare Grundierung auf Basis eines aminmodifizierten Polyetheracrylats und eines weiteren Polyetheracrylats mit einer Walze appliziert, angeliert und ausgehärtet. Nach Schleifen der Oberfläche wird ein handelsüblicher UV-härtbarer Decklack aufgetragen und endgehärtet. Die Haftungseigenschaften der Lackoberfläche sind in Tabelle 1 wiedergegeben.

### Beispiel 2:

In 80 Teile einer 50%igen Polyesteracrylatemulsion (Laromer® LR 8895 der Fa. BASF AG) werden 19 Teile eines Polyetheracrylats (Laromer® LR 8967 der Fa. BASF AG) eindispergiert und mit 1 % eines Photoinitiatorgemisches aus Benzophenon und 1-Hydroxycyclohexylphenylketon im Gewichtverhältnis 1:1 (Irgacure® 500, Photoinitiator der Fa. Ciba) versetzt. Es wird eine stabile Emulsion erhalten. Der Feststoffgehalt liegt bei 60 %. Diese Beschichtungsmasse wird in einer Schichtstärke von ca. 5 - 8 g/m² auf eine Buchenberfläche aufgewalzt und mit einem Strahler (120 W/cm) angeliert. Danach wird ein Standardaufbau, bestehend aus Grund- und Decklack wie in Beispiel 1 aufgetragen.

### Beispiel 3:

40 Teile einer 50%igen Emulsion eines Polyesteracrylats (Laromer® PE 55 W der BASF AG) werden mit 60 Teilen eines Melaminacrylates (Laromer® LR 8794 der Fa. BASF AG) homogen gemischt und nach Zugabe von 2 % 4-(2-Hydroxyethoxy)phenyl-(2-hydroxy-2-methylpropyl)keton (Irgacure® 2959, Photoinitiator der Fa. Ciba) in einer Schichtdicke von 10 g/m² mittels walze auf eine Buchenberfläche appliziert und mit einem Strahler (120 W/cm, Fa. IST) angeliert. Danach wird ein Standardaufbau, bestehend aus Grund- und Decklack wie in Beispiel 1 aufgetragen.

### Vergleich:

Ein Lackaufbau gemäß den Beispielen 1 bis 3 wird auf eine Buchenholzoberfläche aufgetragen, die zuvor nicht mit einem Primer behandelt wurde.

Zur Beurteilung der strahlungsgehärteten Oberflächen wird der Gitterschnitt-Wert nach ISO 2409, DIN 53151 ermittelt. Die Ergebnisse sind in Tabelle 1 wiedergegeben.

**Tabelle 1**

| Beispiel-Nr. | | | |
|---|---|---|---|
| 1 | 2 | 3 | Vergleich |
| 0-1 | 0-1 | 0-1 | 4 |

Wie die Ergebnisse in Tabelle 1 belegen weisen die mit einem erfindungsgemäßen, strahlungshärtbaren Primer behandelten Oberflächen deutlich bessere Gitterschnitt-Werte auf, als vor dem Lackauftrag nicht behandelte Oberflächen.

## Patentansprüche

1. Verfahren zur Herstellung beschichteter Oberflächen, **dadurch gekennzeichnet, dass** man
i) eine wässrige, strahlungshärtbare Beschichtungsmasse auf die Oberfläche aufträgt, enthaltend:
a) 5,0 bis 90,0 Gew.-% mindestens eines wasserdispergierbaren Polymerisats P, umfassend wenigstens eine α,β-ethylenisch ungesättigte, durch Strahlung polymerisierbare Doppelbindung,
b) 0,1 bis 90 Gew.-% mindestens einer von P verschiedenen, wasserlöslichen oder mit mindestens 10 Gew.-% Wasser, bezogen auf das Gesamtgewicht der Beschichtungsmasse, verdünnbaren, strahlungshärtbaren Verbindung S, die wenigstens eine α,β-ethylenisch ungesättigte, durch Strahlung polymerisierbare Doppelbindung umfasst,
c) 0 bis 20 Gew.-% eines Photoinitiators,
d) 0 bis 60 Gew.-% eines Füllstoffs,
e) 0 bis 20 Gew.-% weitere Zusatzstoffe,
f) Wasser ad 100 Gew.-%,
ii) die aufgetragene Beschichtungsmasse durch Bestrahlung mit UV- oder Elektronenstrahlen härtet,
iii) mindestens einen weiteren strahlungshärtbaren Lack auf die beschichtete Oberfläche aufträgt und härtet.

2. Verfahren nach Anspruch 1, wobei das Polymerisat P ausgewählt ist unter Estern α,β-ethylenisch ungesättigter Monocarbonsäuren mit Hydroxylgruppen-haltigen Polykondensaten Pk, Estern α,β-ethylenisch ungesättigter Dicarbonsäurehalbester mit Polykondensaten Pk, Ethern α,β-ethylenisch ungesättigter Alkohole mit Polykondensaten Pk, α,β-ethylenische Doppelbindungen enthaltenden Epoxidharzderivaten, α,β-ethylenische Doppelbindungen enthaltenden Polyurethanderivaten, sowie Polymeren mit sich wiederholenden Einheiten, die Acylreste mit α,β-ethylenischen Doppelbindungen enthalten, und Mischungen davon.

3. Verfahren nach Anspruch 2, wobei das Polykondensat Pk ausgewählt ist unter Polyestern, die gegebenenfalls Ethergruppen enthalten, Polyethern, die gegebenenfalls Estergruppen enthalten, Alkoxilaten zwei- oder mehrwertiger Alkohole, Polyalkylenglykolen, Polyadditionspolymerisaten cyclischer Ether, und Mischungen und Copolymerisaten davon.

4. Verfahren nach einem der vorhergehenden Ansprüche, wobei die Verbindung S mit mindestens 15 Gew.-%, bevorzugt mit mindestens 20 Gew.-%, Wasser, bezogen auf das Gesamtgewicht der Beschichtungsmasse, verdünnbar ist.

5. Verfahren nach einem der vorhergehenden Ansprüche, wobei die Verbindung S ausgewählt ist unter Epoxidacrylaten, Epoxidmethacrylaten, Polyetheracrylaten, Polyethermethacrylaten, Polyesteracrylaten, Polyestermethacrylaten, Polyurethanacrylaten, Polyurethanmethacrylaten, Melaminacrylaten, Melaminmethacrylaten, Verdickern, und Mischungen davon.

6. Verfahren nach einem der vorhergehenden Ansprüche, wobei
I) das Polymerisat P ein Ester α,β-ethylenisch ungesättigter Monocarbonsäuren mit Hydroxylgruppen-haltigen Polykondensaten Pk und die Verbindung S ein Epoxidacrylat, Epoxidmethacrylat, Polyetheracrylat oder Polyethermethacrylat ist, oder
II) das Polymerisat P ein α,β-ethylenische Doppelbindungen enthaltendes Polyurethanderivat und die Verbindung S ein Polyurethanverdicker mit α,β-ethylenisch ungesättigten, durch Strahlung polymerisierbaren Doppelbindungen ist, oder
III) das Polymerisat P ein α,β-ethylenische Doppelbindungen enthaltendes Polyurethanderivat und die Verbindung S ein Verdicker auf Acrylatbasis mit α,β-ethylenisch ungesättigten, durch Strahlung polymerisierbaren Doppelbindungen ist, oder
IV) das Polymerisat P ein Ester α,β-ethylenisch ungesättigter Monocarbonsäuren mit Hydroxylgruppen-haltigen Polykondensaten Pk und die Verbindung S ein Melaminacrylat oder Melaminmethacrylat ist.

7. Verfahren nach Anspruch 1, **dadurch gekennzeichnet, dass** die Grundierung nach dem Auftragen auf die Oberfläche in Schritt i) vor der Bestrahlung nicht zusätzlich getrocknet wird.

8. Verwendung der Beschichtungsmassen wie in einem der Ansprüche 1 bis 6 definiert als Primer, insbesondere unter strahlungshärtbaren Lacken.

9. Verwendung nach Anspruch 8 als Primer für nicht saugfähige Oberflächen, bevorzugt Metalle, Kunststoffe und Textilsynthesefasern, oder als Primer für saugfähige Substrate, bevorzugt Holz, Holzwerkstoffe, Papier, Baumwolle und Leder.

10. Wässrige, strahlungshärtbare Beschichtungsmassen, enthaltend:
a) 5,0 bis 90,0 Gew.-% mindestens eines wasserdispergierbaren Polymerisats P, umfassend wenigstens eine α,β-ethylenisch ungesättigte, durch Strahlung polymerisierbare Doppelbindung, wobei das Polymerisat P ausgewählt ist unter Estern α,β-ethylenisch ungesättigter Monocarbonsäuren mit Hydroxylgruppen-haltigen Polykondensaten Pk, Estern α,β-ethylenisch ungesättigter Dicarbonsäurehalbester mit Polykondensaten Pk, Ethern α,β-ethylenisch ungesättigter Alkohole mit Polykondensaten Pk, α,β-ethylenische Doppelbindungen enthaltenden Epoxidharzderivaten, sowie Polymeren mit sich wiederholenden Einheiten, die Acylreste mit α,β-ethylenischen Doppelbindungen enthalten, und Mischungen davon,
b) 0,1 bis 90 Gew.-% mindestens einer von P verschiedenen, wasserlöslichen oder mit mindestens 10 Gew.-% Wasser, bezogen auf das Gesamtgewicht der Beschichtungsmasse, verdünnbaren, strahlungshärtbaren Verbindung S, die wenigstens eine α,β-ethylenisch ungesättigte, durch Strahlung polymerisierbare Doppelbindung umfasst, wobei die Verbindung S ausgewählt ist unter Epoxidacrylaten, Epoxidmethacrylaten, Polyetheracrylaten, Polyethermethacrylaten, Polyesteracrylaten, Polyestermethacrylaten, Melaminacrylaten, Melaminmethacrylaten, Verdickern, und Mischungen davon,
c) 0 bis 20 Gew.-% eines Photoinitiators,
d) 0 bis 60 Gew.-% eines Füllstoffs,
e) 0 bis 20 Gew.-% weitere Zusatzstoffe,
f) Wasser ad 100 Gew.-%.

11. Beschichtungsmassen nach Anspruch 10, wobei das Polykondensat Pk ausgewählt ist unter Polyestern, die gegebenenfalls Ethergruppen enthalten, Polyethern, die gegebenenfalls Estergruppen enthalten, Alkoxilaten zwei- oder mehrwertiger Alkohole, Polyalkylenglykolen, Polyadditionspolymerisaten cyclischer Ether, und Mischungen und Copolymerisaten davon.

12. Beschichtungsmassen nach einem der Ansprüche 10 oder 11, wobei
I) das Polymerisat P ein Ester α,β-ethylenisch ungesättigter Monocarbonsäuren mit Hydroxylgruppen-haltigen Polykondensaten Pk und die Verbindung S ein Epoxidacrylat, Epoxidmethacrylat, Polyetheracrylat oder Polyethermethacrylat ist, oder
II) das Polymerisat P ein Ester α,β-ethylenisch ungesättigter Monocarbonsäuren mit Hydroxylgruppen-haltigen Polykondensaten Pk und die Verbindung S ein Melaminacrylat oder Melaminmethacrylat ist.

## Claims

1. A process for preparing coated surfaces, which comprises:
i) applying an aqueous, radiation-curable coating composition to the surface comprising
a) from 5.0 to 90.0% by weight of at least one water-dispersible polymer P comprising at least one α,β-ethylenically unsaturated, radiation-polymerizable double bond,
b) from 0.1 to 90% by weight of at least one radiation-curable compound S which is different from P and which is soluble in water or is dilutable with at least 10% by weight of water, based on the overall weight of the coating composition, and which comprises at least one α,β-ethylenically unsaturated, radiation-polymerizable double bond,
c) from 0 to 20% by weight of a photoinitiator,
d) from 0 to 60% by weight of a filler,
e) from 0 to 20% by weight of further additives,
f) water to 100% by weight,
ii) curing the applied coating composition by irradiation with UV radiation or electron beams,
iii)applying at least one further radiation-curable coating material to the coated surface, and carrying out curing.

2. A process as claimed in claim 1 where the polymer P is selected from esters of α,β-ethylenically unsaturated monocarboxylic acids with hydroxyl-containing polycondensates Pk, esters of α,β-ethylenically unsaturated dicarboxylic monoesters with polycondensates Pk, ethers of α,β-ethylenically unsaturated alcohols with polycondensates Pk, epoxy resin derivatives containing α,β-ethylenic double bonds, polyurethane derivatives containing α,β-ethylenic double bonds, and polymers with repeating units which comprise acyl residues having α,β-ethylenic double bonds, and mixtures thereof.

3. A process as claimed in claim 2, where the polycondensate Pk is selected from polyesters with or without ether groups, polyethers with or without ester groups, alkoxylates of dihydric or polyhydric alcohols, polyalkylene glycols, polyaddition polymers of cyclic ethers, and mixtures and copolymers thereof.

4. A process as claimed in any of the preceding claims, where the compound S is dilutable with at least 15% by weight, preferably with at least 20% by weight, of water, based on the overall weight of the coating composition.

5. A process as claimed in any of the preceding claims, where the compound S is selected from epoxy acrylates, epoxy methacrylates, polyether acrylates, polyether methacrylates, polyester acrylates, polyester methacrylates, polyurethane acrylates, polyurethane methacrylates, melamine acrylates, melamine methacrylates, thickeners, and mixtures thereof.

6. A process as claimed in any of the preceding claims, where
I) the polymer P is an ester of α,β-ethylenically unsaturated monocarboxylic acids with hydroxyl-containing polycondensates Pk and the compound S is an epoxy acrylate, epoxy methacrylate, polyether acrylate or polyether methacrylate, or
II) the polymer P is a polyurethane derivative which contains α,β-ethylenic double bonds, and the compound S is a polyurethane thickener with α,β-ethylenically unsaturated, radiation-polymerizable double bonds, or
III)the polymer P is a polyurethane derivative containing α,β-ethylenic double bonds, and the compound S is an acrylate-based thickener with α,β-ethylenically unsaturated, radiation-polymerizable double bonds, or
IV) the polymer P is an ester of α,β-ethylenically unsaturated monocarboxylic acids with hydroxyl-containing polycondensates Pk and the compound S is a melamine acrylate or melamine methacrylate.

7. A process as claimed in claim 1, wherein the primer, following application to the surface in step i), is not additionally dried prior to irradiation.

8. The use of a coating composition as defined in any of claims 1 to 6 as a primer, especially beneath radiation-curable coating materials.

9. The use as claimed in claim 8 as a primer for nonabsorbent surfaces, preferably metals, plastics and synthetic textile fibers, or as a primer for absorbent substrates, preferably wood, wood-derived materials, paper, cotton and leather.

10. An aqueous, radiation-curable coating composition comprising:
a) from 5.0 to 90.0% by weight of at least one water-dispersible polymer P comprising at least one α,β-ethylenically unsaturated, radiation-polymerizable double bond, where the polymer P is selected from esters of α,β-ethylenically unsaturated monocarboxylic acids with hydroxyl-containing polycondensates Pk, esters of α,β-ethylenically unsaturated dicarboxylic monoesters with polycondensates Pk, ethers of α,β-ethylenically unsaturated alcohols with polycondensates Pk, epoxy resin derivatives containing α,β-ethylenic double bonds, and polymers with repeating units which comprise acyl residues having α,β-ethylenic double bonds, and mixtures thereof,
b) from 0.1 to 90% by weight of at least one radiation-curable compound S which is different from P and which is soluble in water or is dilutable with at least 10% by weight of water, based on the overall weight of the coating composition, and which comprises at least one α,β-ethylenically unsaturated,
radiation-polymerizable double bond, where the compound S is selected from epoxy acrylates, epoxy methacrylates, polyether acrylates, polyether methacrylates, polyester acrylates, polyester methacrylates, melamine acrylates, melamine methacrylates, thickeners, and mixtures thereof,
c) from 0 to 20% by weight of a photoinitiator,
d) from 0 to 60% by weight of a filler,
e) from 0 to 20% by weight of further additives,
f) water to 100% by weight.

11. A coating composition as claimed in claim 10, where the polycondensate Pk is selected from polyesters with or without ether groups, polyethers with or without ester groups, alkoxylates of dihydric or polyhydric alcohols, polyalkylene glycols, polyaddition polymers of cyclic ethers, and mixtures and copolymers thereof.

12. A coating composition as claimed in either of claims 10 and 11, where
I) the polymer P is an ester of α,β-ethylenically unsaturated monocarboxylic acids with hydroxyl-containing polycondensates Pk and the compound S is an epoxy acrylate, epoxy methacrylate, polyether acrylate or polyether methacrylate, or
II) the polymer P is an ester of α,β-ethylenically unsaturated monocarboxylic acids with hydroxyl-containing polycondensates Pk and the compound S is a melamine acrylate or melamine methacrylate.

## Revendications

1. Procédé de production de surfaces revêtues, **caractérisé en ce que** l'on
i) dépose une masse de revêtement aqueuse durcissable par irradiation contenant :
a) 5,0% à 90% en poids d'au moins un polymère P dispersible dans l'eau, comprenant au moins une double liaison à insaturation α,β-éthylénique polymérisable par irradiation,
b) 0,1% à 90% en poids d'au moins un composé S, différent de P, soluble dans l'eau ou diluable avec au moins 10% en poids d'eau par rapport à la quantité totale de la masse de revêtement, durcissable par irradiation, qui comprend au moins une double liaison à insaturation α,β-éthylénique polymérisable par irradiation,
c) 0% à 20% en poids d'un photoamorceur,
d) 0% à 20% en poids d'une charge,
e) 0% à 20% en poids d'autres adjuvants,
f) le complément d'eau pour atteindre 100% en poids,
ii) durcit la masse de revêtement déposée au moyen d'une irradiation à l'aide de rayons UV ou de rayons électroniques,
iii) dépose au moins un vernis supplémentaire durcissable par irradiation sur la surface revêtue et on durcit.

2. Procédé selon la revendication 1, dans lequel le polymère P est choisi parmi les esters d'acides monocarboxyliques à insaturation α,β-éthylénique comprenant des polycondensats Pc contenant des groupes hydroxyle, les hémi-esters d'acides dicarboxyliques à insaturation α,β-éthylénique comprenant des polycondensats Pc, les éthers d'alcools à insaturation α,β-éthylénique comprenant des polycondensats Pc, les dérivés de résine époxy contenant des doubles liaisons à insaturation α,β-éthylénique, les dérivés de polyuréthanne contenant des doubles liaisons à insaturation α,β-éthylénique ainsi que les polymères à motifs récurrents qui contiennent des groupes acyle présentant des doubles liaisons à insaturation α,β-éthylénique et les mélanges de ceux-ci.

3. Procédé selon la revendication 2, dans lequel le polycondensat Pc est choisi parmi les polyesters, qui contiennent éventuellement des groupes éther, les polyéthers, qui contiennent éventuellement des groupes ester, les alcanolates de diols ou de polyols, les polyalkylèneglycols, les polymères de polyaddition d'éthers cycliques, et les mélanges et les copolymères de ceux-ci.

4. Procédé selon l'une quelconque des revendications précédentes, dans lequel le composé S est diluable avec au moins 15% en poids, de préférence avec au moins 20% en poids d'eau, par rapport au poids total de la masse de revêtement.

5. Procédé selon l'une quelconque des revendications précédentes, dans lequel le composé S est choisi parmi les acrylates d'époxyde, les méthacrylates d'époxyde, les polyéther-acrylates, les polyéther-méthacrylates, les polyester-acrylates, les polyester-méthacrylates, les polyuréthanne-acrylates, les poly-uréthanne-méthacrylates, les acrylates de mélamine, les méthacrylates de mélamine, les épaississants et les mélanges de ceux-ci.

6. Procédé selon l'une quelconque des revendications précédentes, dans lequel
I) le polymère P est un ester d'acides monocarboxyliques à insaturation α,β-éthylénique comprenant des polycondensats Pc contenant des groupes hydroxyle et le composé S est un acrylate d'époxyde, un méthacrylate d'époxyde, un polyéther-acrylate ou un polyéther-méthacrylate, ou
II) le polymère P est un dérivé de polyuréthanne contenant des doubles liaisons à insaturation α,β-éthylénique et le composé S est un épaississant polyuréthanne contenant des doubles liaisons à insaturation α,β-éthylénique durcissables par irradiation, ou
III) le polymère P est un dérivé de polyuréthanne contenant des doubles liaisons à insaturation α,β-éthylénique et le composé S est un épaississant à base d'acrylate contenant des doubles liaisons à insaturation α,β-éthylénique durcissables par irradiation, ou
IV) le polymère P est un ester d'acides monocarboxyliques à insaturation α,β-éthylénique comprenant des polycondensats Pc contenant des groupes hydroxyle et le composé S est un acrylate de mélamine ou un méthacrylate de mélamine.

7. Procédé selon a revendication 1, **caractérisé en ce que** l'apprêt suite au dépôt sur la surface dans l'étape i) avant l'irradiation n'est pas de plus séché.

8. Utilisation des masses de revêtement tel que défini dans l'une quelconque des revendications 1 à 6 en tant qu'apprêt, en particulier sous des vernis durcissables par irradiation.

9. Utilisation selon la revendication 8 en tant qu'apprêt pour des surfaces non absorbantes, de préférence pour les métaux, les matières plastiques et les fibres textiles synthétiques, ou en tant qu'apprêt pour des substrats absorbants, de préférence pour le bois, les matériaux dérivés du bois, le papier, le coton et le cuir.

10. Masses de revêtement aqueuses durcissables par irradiation, contenant :
a) 5,0% à 90% en poids d'au moins un polymère P dispersible dans l'eau, comprenant au moins une double liaison à insaturation α,β-éthylénique polymérisable par irradiation, le polymère P étant choisi parmi les esters d'acides monocarboxyliques à insaturation α,β-éthylénique comprenant des polycondensats Pc contenant des groupes hydroxyle, les hémi-esters d'acides dicarboxyliques à insaturation α,β-éthylénique comprenant des polycondensats Pc, les éthers d'alcools à insaturation α,β-éthylénique comprenant des polycondensats Pc, les dérivés de résine époxy contenant des doubles liaisons à insaturation α,β-éthylénique ainsi que les polymères à motifs récurrents qui contiennent des groupes acyle présentant des doubles liaisons à insaturation α,β-éthylénique et les mélanges de ceux-ci.
b) 0,1% à 90% en poids d'au moins un composé S, différent de P, soluble dans l'eau ou comprenant au moins 10% en poids d'eau par rapport à la quantité totale de la masse de revêtement, diluable, durcissable par irradiation, qui comprend au moins une double liaison à insaturation α,β-éthylénique polymérisable par irradiation, le composé S étant choisi parmi les acrylates d'époxyde, les méthacrylates d'époxyde, les polyéther-acrylates, les polyéther-méthacrylates, les polyester-acrylates, les polyester-méthacrylates, les acrylates de mélamine, les méthacrylates de mélamine, les épaississants et les mélanges de ceux-ci.
c) 0% à 20% en poids d'un photoamorceur,
d) 0% à 60% en poids d'une charge,
e) 0% à 20% en poids d'autres adjuvants,
f) le complément d'eau pour atteindre 100% en poids.

11. Masses de revêtement selon la revendication 10, dans lesquelles le polycondensat Pc est choisi parmi les polyesters, qui contiennent éventuellement des groupes éther, les polyéthers, qui contiennent éventuellement des groupes ester, les alcanolates de diols ou de polyols, les polyalkylèneglycols, les polymères de polyaddition d'éthers cycliques, et les mélanges et les copolymères de ceux-ci.

12. Masses de revêtement selon l'une quelconque des revendications 10 ou 11, dans lesquelles
I) le polymère P est un ester d'acide monocarboxylique à insaturation α,β-éthylénique comprenant des polycondensats Pc contenant des groupes hydroxyle et le composé S est un acrylate d'époxyde, un méthacrylate d'époxyde, un polyéther-acrylate bu un polyéther-méthacrylate, ou
II) le polymère P est un ester d'acide monocarboxylique à insaturation α,β-éthylénique comprenant des polycondensats Pc contenant des groupes hydroxyle et le composé S est un acrylate de mélamine ou un méthacrylate de mélamine.
